# EUROPEAN PATENT SPECIFICATION

(11) **EP 4 514 098 B1**
(45) Date of publication and mention of the grant of the patent: **05.08.2026**
(21) Application number: 24195290.2
(22) Date of filing: 20.08.2024
(51) Int. Cl.: H10H 29/30, H10H 29/855, H10H 29/856

(54) **A DISPLAY DEVICE INCLUDING A SEMICONDUCTOR LIGHT EMITTING DEVICE**
ANZEIGEVORRICHTUNG MIT EINER LICHTEMITTIERENDEN HALBLEITERVORRICHTUNG
DISPOSITIF D'AFFICHAGE COMPRENANT UN DISPOSITIF ÉLECTROLUMINESCENT À SEMI-CONDUCTEUR

(30) Priority: 24.08.2023 KR 20230111347
(43) Date of publication of application: 26.02.2025
(73) Proprietor: LG Electronics Inc., Yeongdeungpo-gu Seoul 07336 (KR)
(72) Inventor: KIM, Seonock, 06772 Seoul (KR); YUH, Hwankuk, 06772 Seoul (KR)
(74) Representative: Vossius & Partner Patentanwälte Rechtsanwälte mbB

(56) References cited:
- EP-A1- 3 316 301
- WO-A1-2023/033572
- WO-A1-2023/277466
- US-A1- 2019 385 991
- US-A1- 2020 212 102
- US-A1- 2021 336 085
- US-A1- 2022 352 249

## Description

### The Background

### 1. The field

The present invention relates to a display device including a semiconductor light emitting device.

### 2. Description of the related art

Large-area displays include liquid crystal displays (LCDs), OLED displays, and Micro-LED displays.

The micro-LED display is a display using a micro-LED, which is a semiconductor light emitting device having a diameter or cross-sectional area of 100µm or less, as a display device.

The Micro-LED display has an excellent performance in many characteristics such as contrast ratio, response speed, color reproduction rate, viewing angle, brightness, resolution, life, luminous efficiency and luminance because it uses the micro-LED which is a semiconductor light emitting device, as a display device.

In particular, the micro-LED display has the advantage of being able to freely adjust the size and resolution and to implement a flexible display because the screen may be separated and combined in a modular manner.

However, there is a technical problem in that it is difficult to quickly and accurately transfer the semiconductor light emitting device to the display panel because more than millions of semiconductor light emitting devices are required for a large micro-LED display.

Transfer technologies that have been recently developed include a pick and place process, a laser lift-off method, or a self-assembly method.

Meanwhile, in a micro-LED display device based on internal technology, a black matrix was placed on a top of the micro-LED. However, when a black matrix is placed on the top of the micro-LED, a problem of a difference in luminance depending on a viewing angle has been studied.

On the other hand, in the internal technology, the black matrix is arranged to surround the micro-LED. In this case, the problem of the black matrix absorbing light and reducing luminance was studied.

US 2019/385991 A1, WO 2023/033572 A1, WO 2023/277466 A1, US 2021/336085 A1 and EP 3316301 A1 disclose a display device including a semiconductor light emitting device.

### The Summary

One of the technical objects of the present invention is to improve light efficiency in the display device.

Additionally, another technical object of the present invention is to improve light uniformity.

Additionally, one of the technical objects of the present invention is to compensate for the decrease in luminance caused by the black filler.

The technical objects of the present invention are not limited to those described in this item and include those that may be understood through the description of the present invention.

The present invention provides a display device according to claim 1.

Additionally, in an embodiment, the semiconductor light emitting device may be located below the area between the first opaque fillers.

Additionally, in an embodiment, the semiconductor light emitting device may not vertically overlap the first opaque filler.

Additionally, in an embodiment, a horizontal width of the light reflective filling layer may be greater than a first distance between the first opaque fillers and may be greater than a second distance between the second opaque fillers.

Additionally, the embodiment may further include a reflective film disposed below the semiconductor light emitting device.

Additionally, in an embodiment, a horizontal width of the reflective film may be greater than the first distance between the first opaque fillers and may be greater than the second distance between the second opaque fillers.

Additionally, in an embodiment, a lower surface of the light reflective filling layer may be located at the same height as the lower surface of the semiconductor light emitting device, and the upper surface of the light reflective filling layer may be located lower than the active layer of the semiconductor light emitting device.

Additionally, in an embodiment, a thickness of the light reflective filling layer may be smaller than a thickness of the semiconductor light emitting device.

Additionally, in an embodiment, the second opaque fillers may be disposed on the planarization layer.

Also, the light reflective filling layer may have a reflectivity of 60% or more.

Also, the embodiment may further include a second planarization layer disposed between the first opaque fillers and the second opaque fillers.

A display device including the semiconductor light emitting device according to the present invention has the technical effect of improving light uniformity.

For example, the present invention may reduce the difference in luminance depending on the viewing angle by disposing a light reflective filling layer surrounding the semiconductor light emitting device.

Additionally, the present invention has a technical effect of improving the brightness of the display device.

For example, as the light reflective filling layer is located lower than the semiconductor light emitting device, light emitted from the sides and bottom of the semiconductor light emitting device may be reflected upward to improve luminance.

The technical effects of the present invention are not limited to those described in this item and include those that may be understood through the description of the invention.

### Brief description of the drawings

FIG. 1 is an exemplary diagram of a living room of a house where a display device according to an embodiment is placed.
FIG. 2 is a block diagram schematically showing a display device according to an embodiment.
FIG. 3 is an enlarged view of the first panel area in the display device of FIG. 1.
FIG. 4 is a cross-sectional view taken along line B1-B2 in area A2 of FIG. 3.
FIG. 5A is a conceptual diagram of a display device not forming part of the present invention.
FIG. 5B is a graph showing the luminance according to the viewing angle of the display device of FIG. 5A.
FIG. 6A is a conceptual diagram of a display device not forming part of the present invention.
FIG. 6B is a graph showing the luminance according to the viewing angle of the display device of FIG. 6A.
FIG. 7 is a conceptual diagram of a disply device including the semiconductor lig example hot forming part of e present invention. emitting device according to an
FIG. 8 is a cross-sectional view showing the semiconductor light emitting device of FIG. 7 in detail.
FIG. 9 is a conceptual diagram of a display device including the semiconductor light emitting device according to an embodiment of the present invention.
FIG. 10 is a conceptual diagram of a disply device including the semic.onductor lig emitting device according to an example not forming part of the present invention.

### The Detailed description

Hereinafter, embodiments of the present invention will be described in detail with reference to the accompanying drawings. The suffixes 'module' and 'part' for components used in the following description are given or mixed in consideration of ease of specification, and do not have a meaning or role distinct from each other by themselves. Also, the accompanying drawings are provided for easy understanding of the embodiments disclosed in the present specification, and the technical ideas disclosed in the present specification are not limited by the accompanying drawings. Also, when an element, such as a layer, area, or substrate, is referred to as being 'on' another component, this includes that it is directly on the other element or there may be other intermediate elements in between.

The display device described in this specification may include a digital TV, a mobile phone, a smart phone, a laptop computer, a digital broadcasting terminal, a personal digital assistant (PDA), a portable multimedia player (PMP), a navigation, a Slate PC, a Tablet PC, an Ultra-Book, a desktop computer, and the like. However, the configuration according to the embodiment described in this specification may be applied to a device capable of displaying even a new product type to be developed in the future.

Hereinafter, a light emitting device according to an embodiment and a display device including the same will be described.

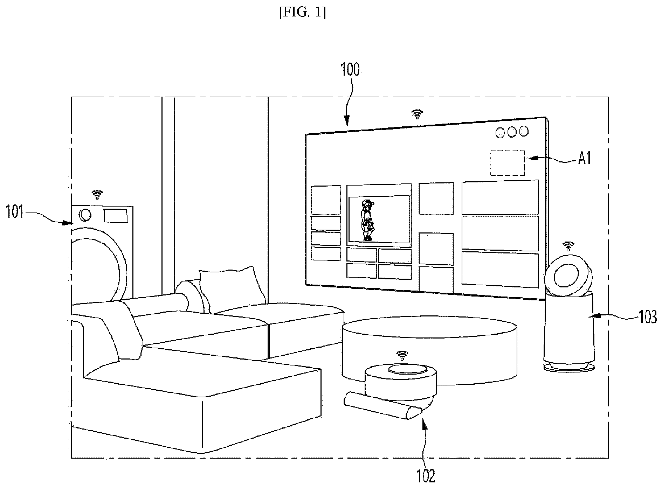

FIG. 1 shows a living room of a house where a display device 100 according to an embodiment is placed.

The display device 100 of the embodiment may display the status of various electronic products such as a washing machine 101, a robot vacuum cleaner 102, and an air purifier 103, may communicate with each electronic product based on IOT and may control each electronic product based on the user's setting data.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the emission of unit pixels arranged in a matrix form. A unit pixel refers to the minimum unit for implementing one color. A unit pixel of a flexible display may be implemented by a light emitting device. In the embodiment, the light emitting device may be Micro-LED or Nano-LED, but is not limited thereto.

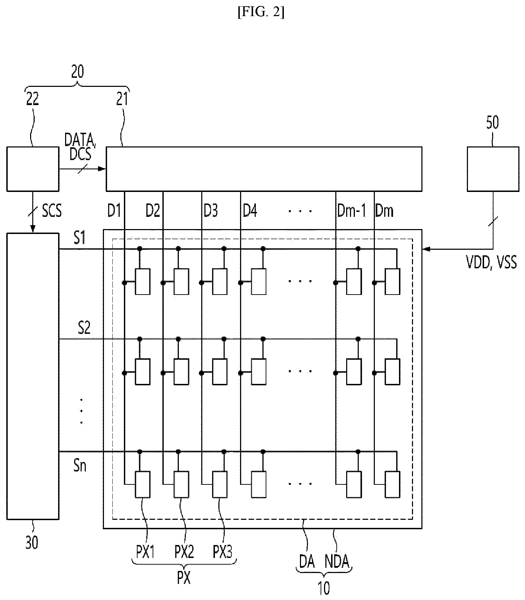

FIG. 2 is a block diagram schematically showing a display device according to an embodiment.

The display device 100 of the embodiment may drive the light emitting element in an active matrix (AM, Active Matrix) method or a passive matrix (PM, Passive Matrix) method.

The driving circuit 20 may include a data driver 21 and a timing control unit 22.

The display panel 10 may be divided into a display area DA and a non-display area NDA disposed around the display area DA. The display area DA is an area in which pixels PX are formed to display an image. The display panel 10 may include data lines (D1 to Dm, m is an integer greater than or equal to 2), scan lines crossing the data lines D1 to Dm (S1 to Sn, n is an integer greater than or equal to 2), the high-potential voltage line supplied with the high-voltage, the low-potential voltage line supplied with the low-potential voltage, and the pixels PX connected to the data lines D1 to Dm and the scan lines S1 to Sn may be included.

Each of the pixels PX may include a first sub-pixel PX1, a second sub-pixel PX2, and a third sub-pixel PX3. The first sub-pixel PX1 emits a first color light of a first wavelength, the second sub-pixel PX2 emits a second color light of a second wavelength, and the third sub-pixel PX3 emits a third color light of a wavelength may be emitted. The first color light may be red light, the second color light may be green light, and the third color light may be blue light, but is not limited thereto. Also, although it is illustrated that each of the pixels PX includes three sub-pixels in FIG. 2, the present invention is not limited thereto. That is, each of the pixels PX may include four or more sub-pixels.

Each of the first sub-pixel (PX1), the second sub-pixel (PX2), and the third sub-pixel (PX3) may be connected to at least one of the data lines D1 to Dm, at least one of the scan lines S1 to Sn, and a high potential voltage line.

The driving circuit 20 outputs signals and voltages for driving the display panel 10. For this purpose, the driving circuit 20 may include a data driver 21 and a timing controller 22.

The data driver 21 receives digital video data (DATA) and source control signal (DCS) from the timing control unit 22. The data driver 21 converts digital video data (DATA) into analog data voltages according to the source control signal (DCS) and supplies them to the data lines (D1 to Dm) of the display panel 10.

The timing control unit 22 receives digital video data (DATA) and timing signals from the host system. Timing signals may include a vertical sync signal, a horizontal sync signal, a data enable signal, and a dot clock. The host system may be an application processor in a smartphone or tablet PC, a monitor, or a system-on-chip in a TV.

The scan driver 30 receives a scan control signal (SCS) from the timing control unit 22. The scan driver 30 generates scan signals according to the scan control signal SCS and supplies them to the scan lines S1 to Sn of the display panel 10. The scan driver 30 may include a plurality of transistors and may be formed in the non-display area NDA of the display panel 10. Alternatively, the scan driver 30 may be formed as an integrated circuit, and in this case, it may be mounted on a gate flexible film attached to the other side of the display panel 10.

The power supply circuit 50 generates a high potential voltage (VDD) and a low potential voltage (VSS) to drive the light emitting devices (LD) of the display panel 10 from the main power supply, so that may supply the high-potential voltage line and the low-potential voltage line of the display panel 10. Additionally, the power supply circuit 50 may generate and supply driving voltages for driving the driving circuit 20 and the scan driver 30 from the main power supply.

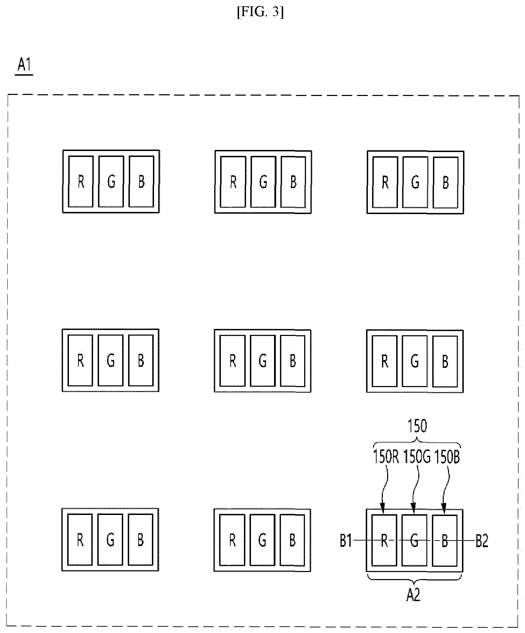

FIG. 3 is an enlarged view of the first panel area A1 in the display device of FIG. 1.

According to FIG. 3, the display device 100 of the embodiment may be manufactured by mechanically and electrically connecting a plurality of panel areas, such as the first panel area A1, by tiling.

The first panel area A1 may include a plurality of light emitting devices 150 arranged for each unit pixel (PX in FIG. 2).

For example, the unit pixel PX may include a first sub-pixel PX1, a second sub-pixel PX2, and a third sub-pixel PX3. For example, a plurality of red light emitting devices 150R are disposed in the first sub-pixel PX1, and a plurality of green light emitting devices 150G are disposed in the second sub-pixel PX2, a plurality of blue light emitting devices 150B may be disposed in the third sub-pixel PX3. The unit pixel PX may further include a fourth sub-pixel in which no light emitting device is disposed, but this is not limited. Meanwhile, the light emitting device 150 may be a semiconductor light emitting device.

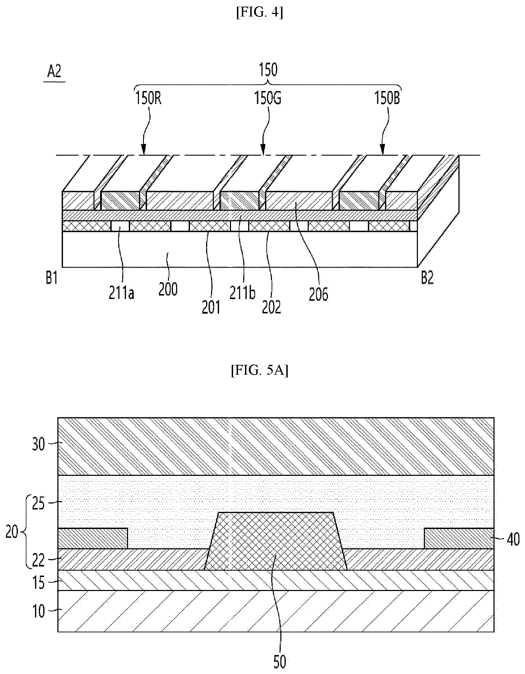

Next, FIG. 4 is a cross-sectional view taken along line B1-B2 in area A2 of FIG. 3.

Referring to FIG. 4, the display device 100 of the embodiment may include a substrate 200, assembly wiring 201 and 202, a first insulating layer 211a, a second insulating layer 211b, a third insulating layer 206, and a plurality of light emitting devices 150.

The assembly wiring may include a first assembly wiring 201 and a second assembly wiring 202 that are spaced apart from each other. The first assembly wiring 201 and the second assembly wiring 202 may be provided to generate dielectrophoretic force to assemble the light emitting device 150. Additionally, the first assembly wiring 201 and the second assembly wiring 202 may be electrically connected to the electrodes of the light emitting device and may function as electrodes of the display panel.

The assembly wiring 201 and 202 may be formed of a translucent electrode (ITO) or may contain a metal material with excellent electrical conductivity. For example, assembly wiring 201, 202 may be formed of at least one of titanium (Ti), chromium (Cr), nickel (Ni), aluminum (Al), platinum (Pt), gold (Au), tungsten (W), and molybdenum (Mo) or an alloy thereof.

The light emitting device 150 may include, but is not limited to, a red light emitting device 150, a green light emitting device 150G, and a blue light emitting device 150B0 to form a unit pixel (sub-pixel), and may include a red phosphor and a green phosphor to implement red and green colors, respectively.

The substrate 200 may be formed of glass or polyimide. Additionally, the substrate 200 may include a flexible material such as PEN (Polyethylene Naphthalate) or PET (Polyethylene Terephthalate). Additionally, the substrate 200 may be made of a light-transmitting material, but is not limited thereto.

The third insulating layer 206 may include an insulating and flexible material such as polyimide, PEN, PET, etc., and may be integrated with the substrate 200 to form one substrate.

The third insulating layer 206 may be a conductive adhesive layer that has adhesiveness and conductivity, and the conductive adhesive layer is flexible and may enable a flexible function of the display device. For example, the third insulating layer 206 may be an anisotropic conductive film (ACF) or a conductive adhesive layer such as an anisotropic conductive medium or a solution containing conductive particles. The conductive adhesive layer may be a layer that is electrically conductive in a direction perpendicular to the thickness, but electrically insulating in a direction horizontal to the thickness.

The third insulating layer 206 may include an assembly hole 203 into which the light emitting device 150 is inserted. Therefore, during self-assembly, the light emitting device 150 may be easily inserted into the assembly hole 203 of the third insulating layer 206. The assembly hole 203 may be called an insertion hole, a fixing hole, an alignment hole, etc.

The gap between the assembly wires 201 and 202 is formed to be smaller than the width of the light emitting device 150 and the width of the assembly hole 203, so that the assembly position of the light emitting device 150 using the badge may be fixed more precisely.

A third insulating layer 206 is formed on the assembly wiring 201 and 202, so that the assembly wirings 201 and 202 may be protected from the fluid 1200 and leakage of current flowing through the assembly wirings 201 and 202 may be prevented. The third insulating layer 206 may be formed as a single layer or multilayer of an inorganic insulator such as silica or alumina or an organic insulator.

Additionally, the third insulating layer 206 may include an insulating and flexible material such as polyimide, PEN, PET, etc., and may be integrated with the substrate 200 to form one substrate.

The third insulating layer 206 may be an adhesive insulating layer or a conductive adhesive layer with conductivity. The third insulating layer 206 is flexible and may enable a flexible function of the display device.

The third insulating layer 206 has a partition wall, and the assembly hole 203 may be formed by the partition wall. For example, when forming the substrate 200, a portion of the third insulating layer 206 is removed, so that each of the light emitting devices 150 may be assembled into the assembly hole 203 of the third insulating layer 206.

An assembly hole 203 where the light emitting devices 150 are coupled is formed in the substrate 200, and the surface where the assembly hole 203 is formed may be in contact with the fluid 1200. The assembly hole 203 may guide the exact assembly position of the light emitting device 150.

Meanwhile, the assembly hole 203 may have a shape and size corresponding to the shape of the light emitting device 150 to be assembled at the corresponding location. Accordingly, it is possible to prevent another light emitting device from being assembled in the assembly hole 203 or a plurality of light emitting devices from being assembled.

Hereinafter, a display device including the semiconductor light emitting device according to an embodiment for solving technical problems will be described with reference to the drawings.

A display device including the semiconductor light emitting device according to an embodiment may use the self-assembly method using the dielectrophoresis force (DEP force) described above, and also the pick-and-place assembly method and the stamp method may be used.

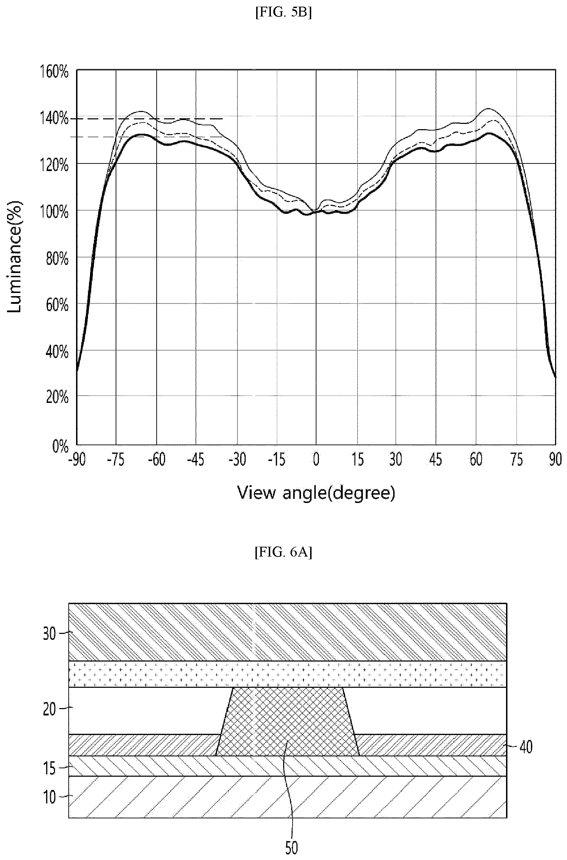

FIGS. 5A and 5B are graphs showing the conceptual diagram and luminance of a display device according to an example not forming part of the present invention.

Referring to FIG. 5A, a semiconductor light emitting device 50 may be disposed on the substrate 10. Additionally, a transparent filler layer 20 may be disposed to cover the semiconductor light emitting device 50. Meanwhile, an opaque filler 40 may be disposed on the transparent filler layer 20. The opaque filler 40 may be a black matrix. The opaque filler 40 may be positioned higher than the lower surface of the semiconductor light emitting device 50 and may be arranged to be spaced apart. The opaque filler 40 may prevent color mixing between pixels. Meanwhile, referring to FIG. 5B, when the opaque filler is located on the top of the semiconductor light emitting device 50, the luminance difference may increase depending on the viewing angle. The luminance varies depending on the position and angle of the semiconductor light emitting device and the opaque filler, and as a result, there is a problem in that light uniformity is deteriorated.

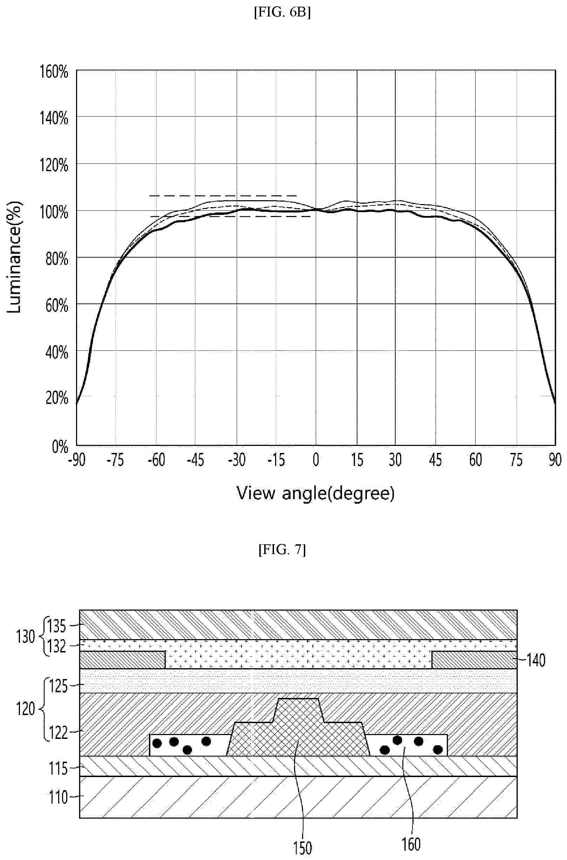

Additionally, referring to FIG. 6A, showing an example not forming part of the present invention, an opaque filler 40 may be disposed to surround the semiconductor light emitting device 50. The opaque filler 40 may be in contact with the side surface of the semiconductor light emitting device. Additionally, the opaque filler may be located lower than the top surface of the semiconductor light emitting device. Meanwhile, referring to FIG. 6B, the display device of FIG. 6A may secure uniformity by having a small luminance deviation depending on the viewing angle, but there is a problem in that luminance is reduced due to light absorption by the opaque filler.

Accordingly, there is a problem in that it is difficult to improve both luminance and light uniformity when only the opaque filler is located on top of the semiconductor light emitting device or when it surrounds the semiconductor light emitting device. However, since display devices using ultra-small micro LEDs require both luminance and light uniformity characteristics, an embodiment that may solve the above problems will be described below.

FIG. 7 is a conceptual diagram of a display device including the semiconductor light emitting device according to an example not forming part of the present invention. Referring to FIG. 7, an adhesive layer 115 may be disposed on the substrate 110. The semiconductor light emitting device 150 may be disposed by being adhered to the adhesive layer 115.

Additionally, a planarization layer 120 may be disposed on the adhesive layer 115. The planarization layer 120 may be called a transparent filling layer filled with a transparent material. Additionally, the planarization layer 120 may have insulating properties.

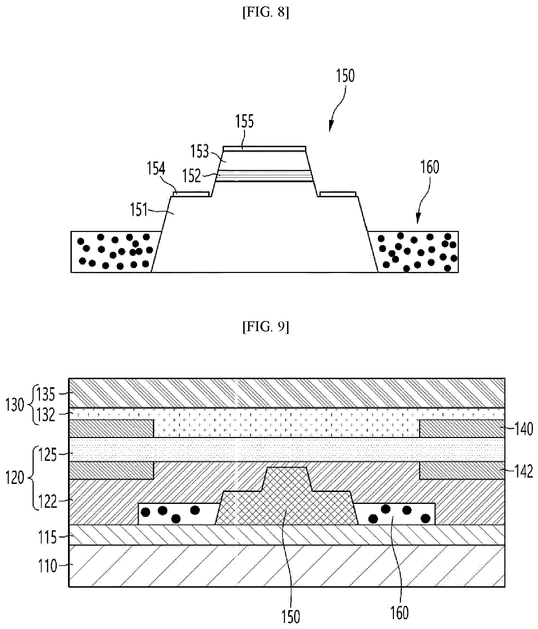

The planarization layer 120 may include a first planarization layer 122 and a second planarization layer 125. The planarization layer 120 may be disposed to cover the semiconductor light emitting device 150. In FIG. 9, showing an embodiment of the present invention, the semiconductor light emitting device 150 is shown in direct contact with the first planarization layer 122.

Meanwhile, a light reflective filling layer 160 may be disposed to surround the semiconductor light emitting device 150. The light reflective filling layer 160 may be filled with a material having a high refractive index. For example, the light reflective filling layer may include at least one of TiO2 or ZrO2, but is not limited thereto. Additionally, the light reflective filling layer 160 may include a photosensitive material and may have a light reflectance of 60% or more. Therefore, in the embodiment, as the light reflective filling layer is arranged to surround the semiconductor light emitting device, there is a technical effect of improving light efficiency by reflecting light exiting the side and bottom of the semiconductor light emitting device upward.

Additionally, in accordance with the present invention, the light reflective filling layer 160 is located lower than the semiconductor light emitting device 150. The lower surface of the light reflective filling layer 160 may be located at the same height as the lower surface of the semiconductor light emitting device 150, the top surface of the light reflective filling layer 160 is located lower than the top surface of the semiconductor light emitting device 150. Additionally, a thickness of the light reflective filling layer 160 may be smaller than a thickness of the semiconductor light emitting device 150. The semiconductor light emitting device 150 and the light reflective filling layer 160 may be covered by a planarization layer 120.

In accordance with the present invention, the side surface of the semiconductor light emitting device 150 includes a first area in contact with the light reflective filling layer 160 and a second area in direct contact with the planarization layer 120. The light reflective filling layer 160 may be located within the first planarization layer 122.

In accordance with the present invention, first opaque fillers 140 are disposed on the planarization layer 120. The first opaque fillers 140 may include a black-based color or a black matrix. The first opaque filler 140 may prevent light leakage in the display device and prevent color mixing between pixels.

In addition, the first opaque fillers 140 are arranged to be spaced apart from each other. The semiconductor light emitting device 150 is located below the first opaque fillers 140. The semiconductor light emitting device 150 may not vertically overlap the first opaque fillers 140 Additionally, the semiconductor light emitting device 150 may not overlap the first opaque fillers 140 in the horizontal direction. Additionally, the horizontal width of the light reflective filling layer 160 may be greater than the distance between the plurality of first opaque fillers. A portion of the light reflecting filling layer 160 may vertically overlap the one or more first opaque filling fillers140.

Additionally, an insulating layer 130 may be disposed on the planarization layer 120. The insulating layer 130 may be called a cover layer. The insulating layer 130 may include a first insulating layer 132 and a second insulating layer 135 disposed on the first insulating layer 132. The first opaque filler 140 may be disposed within or on the first insulating layer 132.

FIG. 8 is a conceptual diagram showing in detail the semiconductor light emitting device 150 of FIG. 7 according to an example not forming part of the present invention. Referring to FIG. 8, the semiconductor light emitting device 150 may be a semiconductor light emitting device with a horizontal structure, but is not limited thereto. The semiconductor light emitting device 150 may include a first conductivity type semiconductor layer 151, an active layer 152, a second conductivity type semiconductor layer 153, a first electrode 154, and a second electrode 155. The first conductivity type semiconductor layer 151 may be an n-type semiconductor layer, and the second conductivity type semiconductor layer 153 may be a p-type semiconductor layer, but are not limited thereto. The first conductivity type semiconductor layer 151, the active layer 152, and the second conductivity type semiconductor layer 153 may be made of a compound semiconductor material. For example, the compound semiconductor material may be a group III-V compound semiconductor material, a group II-VI compound semiconductor material, etc. For example, the compound semiconductor may be may be selected from the group including of a binary compound selected from the group including of GaP, GaAs, GaSb, AIP, AlAs, AlSb, InP, InAs, InSb and mixtures thereof, a three-element compound selected from the group including of GaNP, GaNAs, GaNSb, GaPAs, GaPSb, AlInP, AINP, AlNAs, AlNSb, AlPAs, AlPSb, InNP, InNAs, InNSb, InPAs, InPSb, GaAlNP and mixtures thereof and quaternary compounds selected from the group including of AlGaInP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb and mixtures thereof. For example, the first conductivity type semiconductor layer 151 may include a first conductivity type dopant, and the second conductivity type semiconductor layer 153 may include a second conductivity type dopant. For example, the first conductivity type dopant may be an n-type dopant such as silicon (Si), and the second conductivity type dopant may be a p-type dopant such as boron (B).

The active layer 152 may be a region that generates light, and may generate light with a specific wavelength band depending on the material properties of the compound semiconductor. Additionally, the active layer may have a multiple quantum well or single quantum well structure, and the wavelength band may be determined by the energy band gap of the compound semiconductor included in the active layer. Therefore, depending on the energy band gap of the compound semiconductor included in the active layer, the semiconductor light emitting device of the embodiment may generate UV light, blue light, green light, and red light.

In addition, a power source may be connected to each of the first electrode 154 and the second electrode 155 of the semiconductor light emitting device 150 to drive the semiconductor light emitting device 150.

Additionally, a light reflective filling layer 160 may be disposed to surround the semiconductor light emitting device 150. The light reflective filling layer 160 may be located lower than the active layer 152. Additionally, the thickness of the light reflective filling layer 160 may be smaller than the thickness of the semiconductor light emitting device 150. The side surface of the semiconductor light emitting device 150 may include a first area in contact with the light reflective filling layer 160 and a second area in contact with the planarization layer. Additionally, the light reflective filling layer 160 may be in contact with the side surface of the first conductivity type semiconductor layer 151 of the semiconductor light emitting device 150.

Accordingly, in this embodiment, as the light reflective filling layer is located lower than the active layer of the semiconductor light emitting device, so that there is a technical effect of improving light efficiency by reflecting light emitted from the lower and side portions of the semiconductor light emitting device upward.

FIG. 9 is a conceptual diagram of a display device including the semiconductor light emitting device according to an embodiment of the present invention. Referring to FIG. 9, the display device further includes second opaque fillers 142 disposed within the planarization layer 120. The second opaque fillers 142 may be disposed within the first planarization layer 122 or on the first planarization layer 122.

The second opaque fillers 142 may be arranged to be vertically spaced apart from the first opaque filler 140. The second opaque fillers 142 and the first opaque fillers 140 may be disposed with the second planarization layer 125 interposed therebetween. Additionally, the second opaque fillers 142 and the first opaque fillers 140 may be arranged to overlap vertically.

Meanwhile, the first opaque fillers 140 may cover the light leak of light emitted at a relatively high angle, and the second opaque fillers 142 may cover the light leak of light emitted at a relatively low angle.

Therefore, in the embodiment, the first opaque fillers and the second opaque fillers are arranged to overlap vertically, when the spacing between semiconductor light emitting devices can be miniaturized, there is a technical effect of further preventing color mixing between a plurality of semiconductor light emitting devices.

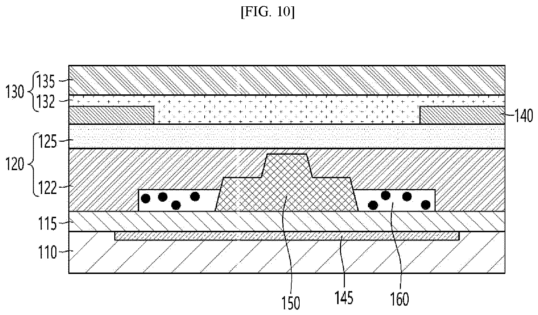

FIG. 10 is a conceptual diagram of a display device including the semiconductor light emitting device according to example not forming part of the present invention. Referring to FIG. 10, the display device further include a reflective film 145 disposed below the semiconductor light emitting device 150. The reflective film 145 may be disposed between the substrate 110 and the adhesive layer 115. Additionally, the light reflective filling layer 160 may be positioned between the first opaque filler 140 and the reflective film 145.

The horizontal width of the reflective film 145 may be larger than the gap between the first opaque fillers 140. Additionally, the horizontal width of the reflective film 145 may be larger than the horizontal width of the light reflective filling layer 160. Accordingly, the example has the technical effect of further improving light efficiency by reflecting light emitted from the bottom of the semiconductor light emitting device 150 toward the top.

A display device including the semiconductor light emitting device according to an embodiment has the technical effect of improving light uniformity.

For example, the embodiment may reduce the difference in luminance depending on the viewing angle by disposing a light reflective filling layer surrounding the semiconductor light emitting device.

Additionally, the embodiment has a technical effect of improving the brightness of the display device.

For example, as the light reflective filling layer is located lower than the semiconductor light emitting device, light emitted from the sides and bottom of the semiconductor light emitting device may be reflected upward to improve luminance.

### [Explanation of refence signs]

| | | | |
|---|---|---|---|
| 110: | substrate | 115: | adhesive layer |
| 120: | planarization layer | 122: | first planarization layer |
| 125: | second planarization layer | 130: | insulating layer |
| 132: | first insulating layer | 135: | second insulating layer |
| 140: | first opaque filler | 142: | second opaque filler |
| 145: | reflective film | 150: | semiconductor light emitting device |
| 160: | light reflective filling layer | | |

## Claims

1. A display device device comprising
a substrate (110);
a semiconductor light emitting device (150) disposed on the substrate (110);
a planarization layer (120) disposed on the semiconductor light emitting device (150); first opaque fillers (140) disposed spaced apart on the planarization layer (120);
second opaque fillers (142) disposed below the first opaque fillers, and
a light reflective filling layer (160) disposed around the semiconductor light emitting device (150),
wherein the light reflective filling layer (160) is positioned lower than a top surface of the semiconductor light emitting device (150),wherein a side surface of the semiconductor light emitting device (150) comprises a first area in contact with the light reflective filling layer (160) and a second area in contact with the planarization layer (120), and
wherein the second opaque fillers (142) are configured to vertically overlap the first opaque fillers (140).

2. The display device according to claim 1, wherein the semiconductor light emitting device (150) is located below the area between the first opaque fillers (140).

3. The display device according to claim 2, wherein the semiconductor light emitting device (150) does not vertically overlap the first opaque fillers (140).

4. The display device according to any one of claims 1 to 3, wherein a horizontal width of the light reflective filling layer (160) is greater than a first distance between the first opaque fillers (140) and is greater than a second distance between the second opaque fillers (142).

5. The display device according to any one of claims 1 to 4, further comprising a reflective film (145) disposed below the semiconductor light emitting device (150).

6. The display device according to claim 5, wherein a horizontal width of the reflective film (145) is greater than the first distance between the first opaque fillers (140) spaced apart and is greater than a second distance between the second opaque fillers (142).

7. The display device according to any one of claims 1 to 6, wherein a lower surface of the light reflective filling layer (160) is located at the same height as a lower surface of the semiconductor light emitting device (150), and an upper surface of the light reflective filling layer (160) is located lower than an active layer of the semiconductor light emitting device (150).

8. The display device according to any one of claims 1 to 7, wherein a thickness of the light reflective filling layer (160) is smaller than a thickness of the semiconductor light emitting device (150).

9. The display device according to any one of claims 1 to 8, wherein the second opaque fillers (142) are disposed on the planarization layer (120).

10. The display device according to any one of claims 1 to 9, wherein a reflectance of the light reflective filling layer (160) is 60% or more.

11. The display device according to any one of claims 1 to 10, wherein the light reflective filling layer (160) comprises either TiO₂ or ZrO₂.

12. The display device according to claim 5, wherein a horizontal width of the reflective film (145) is greater than the horizontal width of the light reflective filling layer (160).

13. The display device according to any one of claims 1 to 12, wherein further comprising a second planarization layer (125) disposed between the first opaque fillers (140) and the second opaque fillers (142).

## Patentansprüche

1. Anzeigevorrichtung, umfassend
ein Substrat (110);
eine Halbleiter-Lichtemissionsvorrichtung (150), die auf dem Substrat (110) angeordnet ist;
eine Planarisierungsschicht (120), die auf der Halbleiter-Lichtemissionsvorrichtung (150) angeordnet ist;
erste opake Füllstoffe (140), die voneinander beabstandet auf der Planarisierungsschicht (120) angeordnet sind;
zweite opake Füllstoffe (142), die unterhalb der ersten opaken Füllstoffe angeordnet sind, und
eine lichtreflektierende Füllschicht (160), die um die Halbleiter-Lichtemissionsvorrichtung (150) herum angeordnet ist,
wobei die lichtreflektierende Füllschicht (160) niedriger als eine Oberseite der Halbleiter-Lichtemissionsvorrichtung (150) positioniert ist, wobei eine Seitenfläche der Halbleiter-Lichtemissionsvorrichtung (150) einen ersten Bereich, der mit der lichtreflektierenden Füllschicht (160) in Kontakt steht, und einen zweiten Bereich, der mit der Planarisierungsschicht (120) in Kontakt steht, umfasst, und
wobei die opaken Füllstoffe (142) dazu ausgelegt sind, die ersten opaken Füllstoffe vertikal zu überlappen.

2. Anzeigevorrichtung gemäß Anspruch 1, wobei sich die Halbleiter-Lichtemissionsvorrichtung (150) unterhalb des Bereichs zwischen den ersten opaken Füllstoffen (140) befindet.

3. Anzeigevorrichtung gemäß Anspruch 2, wobei die Halbleiter-Lichtemissionsvorrichtung (150) die ersten opaken Füllstoffe (140) nicht vertikal überlappt.

4. Anzeigevorrichtung gemäß einem der Ansprüche 1 bis 3, wobei eine horizontale Breite der lichtreflektierenden Füllschicht (160) größer ist als ein erster Abstand zwischen den ersten opaken Füllstoffen (140) und größer ist als ein zweiter Abstand zwischen den zweiten opaken Füllstoffen (142).

5. Anzeigevorrichtung gemäß einem der Ansprüche 1 bis 4, ferner umfassend einen reflektierenden Film (145), der unterhalb der Halbleiter-Lichtemissionsvorrichtung (150) angeordnet ist.

6. Anzeigevorrichtung gemäß Anspruch 5, wobei eine horizontale Breite des reflektierenden Films (145) größer ist als der erste Abstand zwischen den voneinander beabstandeten ersten opaken Füllstoffen (140) und größer ist als ein zweiter Abstand zwischen den zweiten opaken Füllstoffen (142).

7. Anzeigevorrichtung gemäß einem der Ansprüche 1 bis 6, wobei eine Unterseite der lichtreflektierenden Füllschicht (160) auf derselben Höhe angeordnet ist wie eine Unterseite der Halbleiter-Lichtemissionsvorrichtung (150), und eine Oberseite der lichtreflektierenden Füllschicht (160) niedriger angeordnet ist als eine aktive Schicht der Halbleiter-Lichtemissionsvorrichtung (150).

8. Anzeigevorrichtung gemäß einem der Ansprüche 1 bis 7, wobei eine Dicke der lichtreflektierenden Füllschicht (160) kleiner ist als eine Dicke der Halbleiter-Lichtemissionsvorrichtung (150).

9. Anzeigevorrichtung gemäß einem der Ansprüche 1 bis 8, wobei die zweiten opaken Füllstoffe (142) auf der Planarisierungsschicht (120) angeordnet sind.

10. Anzeigevorrichtung gemäß einem der Ansprüche 1 bis 9, wobei ein Reflexionsgrad der lichtreflektierenden Füllschicht (160) 60 % oder mehr beträgt.

11. Anzeigevorrichtung gemäß einem der Ansprüche 1 bis 10, wobei die lichtreflektierende Füllschicht (160) entweder TiO₂ oder ZrO₂ umfasst.

12. Anzeigevorrichtung gemäß Anspruch 5, wobei eine horizontale Breite des reflektierenden Films (145) größer ist als die horizontale Breite der lichtreflektierenden Füllschicht (160).

13. Anzeigevorrichtung gemäß einem der Ansprüche 1 bis 12, ferner umfassend eine zweite Planarisierungsschicht (125), die zwischen den ersten opaken Füllstoffen (140) und den zweiten opaken Füllstoffen (142) angeordnet ist.

## Revendications

1. Dispositif d'affichage, comprenant
un substrat (110) ;
un dispositif électroluminescent à semi-conducteur (150) disposé sur le substrat (110) ;
une couche de planarisation (120) disposée sur le dispositif électroluminescent à semi-conducteur (150) ;
des premières charges opaques (140) disposées de manière espacée sur la couche de planarisation (120) ;
des secondes charges opaques (142) disposées au-dessous des premières charges opaques, et
une couche de remplissage réfléchissant la lumière (160) disposée autour du dispositif électroluminescent à semi-conducteur (150),
dans lequel la couche de remplissage réfléchissant la lumière (160) est positionnée plus bas qu'une surface supérieure du dispositif électroluminescent à semi-conducteur (150), dans lequel une surface latérale du dispositif électroluminescent à semi-conducteur (150) comprend une première zone en contact avec la couche de remplissage réfléchissant la lumière (160) et une seconde zone en contact avec la couche de planarisation (120), et
dans lequel les charges opaques (142) sont configurées pour chevaucher verticalement les premières charges opaques.

2. Dispositif d'affichage selon la revendication 1, dans lequel le dispositif électroluminescent à semi-conducteur (150) est situé au-dessous de la zone entre les premières charges opaques (140).

3. Dispositif d'affichage selon la revendication 2, dans lequel le dispositif électroluminescent à semi-conducteur (150) ne chevauche pas verticalement les premières charges opaques (140).

4. Dispositif d'affichage selon l'une quelconque des revendications 1 à 3, dans lequel une largeur horizontale de la couche de remplissage réfléchissant la lumière (160) est supérieure à une première distance entre les premières charges opaques (140) et est supérieure à une seconde distance entre les secondes charges opaques (142).

5. Dispositif d'affichage selon l'une quelconque des revendications 1 à 4, comprenant en outre un film réfléchissant (145) disposé au-dessous du dispositif électroluminescent à semi-conducteur (150).

6. Dispositif d'affichage selon la revendication 5, dans lequel une largeur horizontale du film réfléchissant (145) est supérieure à la première distance entre les premières charges opaques (140) espacées les unes des autres et est supérieure à une seconde distance entre les secondes charges opaques (142).

7. Dispositif d'affichage selon l'une quelconque des revendications 1 à 6, dans lequel une surface inférieure de la couche de remplissage réfléchissant la lumière (160) est située à la même hauteur qu'une surface inférieure du dispositif électroluminescent à semi-conducteur (150), et une surface supérieure de la couche de remplissage réfléchissant la lumière (160) est située plus bas qu'une couche active du dispositif électroluminescent à semi-conducteur (150).

8. Dispositif d'affichage selon l'une quelconque des revendications 1 à 7, dans lequel une épaisseur de la couche de remplissage réfléchissant la lumière (160) est inférieure à une épaisseur du dispositif électroluminescent à semi-conducteur (150).

9. Dispositif d'affichage selon l'une quelconque des revendications 1 à 8, dans lequel les secondes charges opaques (142) sont disposées sur la couche de planarisation (120).

10. Dispositif d'affichage selon l'une quelconque des revendications 1 à 9, dans lequel une réflectance de la couche de remplissage réfléchissant la lumière (160) est de 60 % ou plus.

11. Dispositif d'affichage selon l'une quelconque des revendications 1 à 10, dans lequel la couche de remplissage réfléchissant la lumière (160) comprend soit du TiO₂, soit du ZrO₂.

12. Dispositif d'affichage selon la revendication 5, dans lequel une largeur horizontale du film réfléchissant (145) est supérieure à la largeur horizontale de la couche de remplissage réfléchissant la lumière (160).

13. Dispositif d'affichage selon l'une quelconque des revendications 1 à 12, comprenant en outre une seconde couche de planarisation (125) disposée entre les premières charges opaques (140) et les secondes charges opaques (142).
